# EUROPEAN PATENT SPECIFICATION

(11) **EP 0 323 714 B1**
(45) Date of publication and mention of the grant of the patent: **20.03.2002**
(21) Application number: 88311524.8
(22) Date of filing: 06.12.1988
(51) Int. Cl.: H01L 29/747

(54) **MOS-controlled bidirectional semiconductor switch**
MOS-gesteuerter Zweiweghalbleiterschalter
Commutateur semi-conducteur bidirectionnel à contrôle du type MOS

(30) Priority: 08.12.1987 US 130143
(43) Date of publication of application: 12.07.1989
(73) Proprietor: Fairchild Korea Semiconductor Ltd., Puchon-City, Kyungki-Do (KR)
(72) Inventor: Forssell, Per N., Minneapolis Minnesota 55413 (US); Huang, Jack S.T., Plymouth Minnesota 55441 (US)
(74) Representative: Tunstall, Christopher Stephen

(56) References cited:
- US-A- 4 199 774
- IEEE TRANSACTIONS ON ELECTRON DEVICES, vol. ED-27, no. 2, February 1980, pages 380-387, IEEE, New York, US; J.D. PLUMMER et al.: "Insulated-gate planar thyristors: I-structure and basic operation"
- EXTENDED ABSTRACTS, vol. 87-1, no. 1, Spring 1987, pages 126-127, Philadephia, PA, US; C.N. DUNN et al.: "A high-voltage dual-gate DMOS structure (DGDMOS)"
- PATENT ABSTRACTS OF JAPAN, vol. 5, no. 133 (E-71)[805], 25th August 1981; & JP-A-56 69 865 (MITSUBISHI DENKI K.K.) 11-06-1981
- INTERNATIONAL ELECTRON DEVICES MEETING, TECHNICAL DIGEST, Washington, D.C., 8th-10th December 1980, pages 75-76, IEEE, New York, US; J. TIHANYI: "Functional integration of power MOS and bipolar devices"
- I.E.E.E. ELECTRON DEVICE LETTERS, vol. EDL-7, no. 2, February 1986, pages 61-63, IEEE, New York, NY, US; A.L. ROBINSON et al.: "Lateral insulated gate transistors with improved latching characteristics"
- S M Sze: "Physics of Semiconductor Devices", 2nd edn., New York: John Wiley & Sons, 1981, pp. 227-228
- J Millman et al.: "Integrated Electronics: Analog and Digital Circuits and Systems", Singapore: McGraw-Hill, 1972, pp. 120-125, 708-715
- IEEE Electron Device Letters, vol. EDL-4, no. 3, March 1983, pp. 63-65 (Russell et al.)

## Description

### BACKGROUND OF THE INVENTION

The present invention relates to semiconductor device structures for switching substantial currents, especially in monolithic integrated circuits, between the states of flowing and not flowing without requiring signal power to maintain the current flowing state and, more particularly, to such device structures where currents flow therethrough in a substantially lateral direction with respect to a surface.

There is an increasing need to control flows of currents of substantial values in monolithic integrated circuits. This comes about primarily because of the desire for "smart" power control - the use of a monolithic integrated circuit with substantial logic or sensing capabilities, or both, to control flows of currents to external devices. The currents drawn by external devices are usually much greater than the signal currents used in monolithic integrated circuits and, in many situations, are orders of magnitude greater than integrated circuit signal currents.

Various kinds of devices have been used as switches to control the initiations and cessations of such higher valued currents in discrete devices and in monolithic integrated circuits. Bipolar transistors have been used to control such higher valued currents, for instance. However, solving problems of thermal "runaway," emitter current crowding and second breakdown lead to devices which take a relatively large amount of area in a monolithic integrated circuit device. In addition, the storage of charge in the base of a bipolar transistor puts a lower limit on the time in which cessation, or switching "off," of a current flowing therethrough can be accomplished. Further, bipolar transistors have a relatively low input impedance.

Metal-oxide-semiconductor field-effect transistors (MOSFET's) have also been used as switches to control the flow of substantial currents because they provide short times for switching off current flows therethrough due to the absence of any charge storage. Furthermore, the negative temperature dependence of the output current eliminates the possibility of thermal "runaway," i.e. an increase in output current with increasing temperatures, a characteristic of bipolar transistors mentioned above. MOSFET's generally have a high input impedance, and therefore a high current gain. A MOSFET power transistor is convenient in integrated circuits where the other active circuit components used in the control logic portion are also MOSFET's, which is often the case. However, the "on" resistance value of a MOSFET is low but not as low as that of a bipolar transistor of the same device area. Further, the "on" resistance of a MOSFET is likely to increase in device designs with higher breakdown voltage capabilities because of design tradeoffs to reach such breakdown voltages.

The value resulting for the "on" resistance in such a switching device is an important consideration. The higher the value of the "on" resistance which occurs for a given current flowing through a current control switching device, the higher the voltage drop across that device between the terminals carrying this flow. This voltage is not available to be provided across the external device to which the current flow is being controlled which, in circuits using small voltage value power supplies as is common in integrated circuits, may be a very difficult characteristic to accept. In addition, especially in integrated circuit chips, the larger the value of the "on" resistance, the greater the power dissipation occurs within the chip which causes the chip to heat. This result may adversely effect other circuit components provided in such an integrated circuit chip. Thus, there is a substantial desire to have a current control switch exhibit as small an "on" resistance as possible.

A further consideration in connection with monolithic integrated circuits having control logic or sensing, or both, provided in common with a power MOSFET in the chip, is the desire to have currents controlled by this power MOSFET flow more or less along that surface of the chip in which the logic devices are also located rather than through the substrate to the opposite side of the chip. Such an arrangement greatly eases the difficulty in making circuit interconnections between the logic devices and the power MOSFET and, in those instances when alternating currents are to be controlled, greatly eases the difficulties in operating the logic or sensing portions of the monolithic integrated circuit chip.

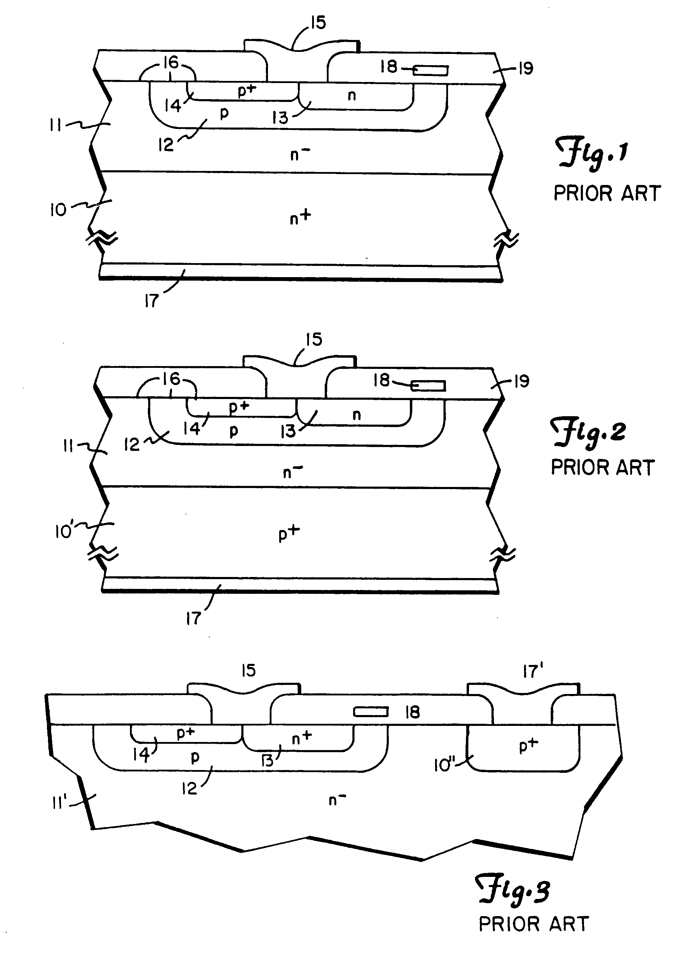

A typical MOSFET device is shown in Figure 1 which is of the well-known DMOS type. A substrate, 10, of n⁺-type conductivity material supports an epitaxial layer, 11, of n⁻-type conductivity material. A portion, 12, of epitaxial layer 11 has been converted to p-type conductivity material through diffusion or ion implantation to form the MOSFET channel region resulting in a semiconductor pn junction between region 12 and remaining portions of layer 11. Within channel region 12, there is formed a n⁺-type conductivity material source, 13, again typically by diffusion or ion implantation. Another semiconductor pn junction results between regions 12 and 13. Adjacent source region 13 is a contact region, 14, formed again by diffusion or ion implantation to have a p⁺-type conductivity. Source region 13 is shorted to channel region 12 through connection region 14 by a metalization contact, 15, electrically contacting regions 13 and 14 at a major surface of the epitaxial layer, 16. A further metalization layer, 17, on the lower side of substrate 10 forms the drain contact.

A conductive material, typically doped polycrystalline silicon or "polysilicon," forms a gate, 18, over the separating space located in both major surface 16 and channel region 12 between the n⁻-type conductivity portions of epitaxial layer 12 and source 13. Gate 18 is separated from channel region 12 by an oxide layer, 19, which surrounds gate 18 and which has an opening to permit source metalization 15 to reach major surface 16. Though not shown, a passivating layer would also be provided over terminal 15 and layer 19.

The MOSFET of the DMOS type shown in Figure 1 can, in the "off" condition, prevent current flow only from drain terminal 17 having a positive voltage thereon with respect to source terminal 15, to that source terminal 15. Such a voltage reverse biases the pn junction between channel region 12 and the remaining portions of layer 11 and substrate 10 connected thereto through being supported thereon. Reversing the polarity of such a voltage will permit a current to flow through the device of Figure 1 from terminal 15 to terminal 17 through regions 14, 12, 11 and 10 even though the gate voltage value is such that this transistor should be "off," which is an unsuitable characteristic for a switching transistor which is to be able to start and stop current flows in either direction. Furthermore, the "on" resistance of the device of Figure 1 is sufficiently large to make this device unattractive in many circuit power supply situations. Finally, as can be seen, this is a vertical MOSFET in that, during operation, currents flow from one major surface of the semiconductor material to the opposite surface. Thus, the device of Figure 1 has some of the undesirable features described above.

The desire for obtaining a device for controlling substantial currents in the monolithic integrated circuit chip which has a lower "on" resistance than an ordinary MOSFET and yet is controlled by an insulated gate or MOSFET-like arrangement logic or sensing section of the chip has led to the development of further alternative circuit component devices. An improvement has been developed to overcome some of these deficiencies and it is shown in Figure 2. Figure 2 differs from Figure 1 in having substituted p⁺-type conductivity material for the n⁺-type conductivity material used for substrate 10 in Figure 1. As a result, substrate 10 of Figure 1 is redesignated 10' in Figure 2. The other designations remain the same for corresponding structures in Figures 1 and 2.

The resulting device, often termed a conductivity modulated field-effect transistor or an insulated gate transistor, is sort of a combination of a MOSFET and a npnp four alternate conductivity type semiconductor layer thyristor device but modified to prevent "latch-up." The "latch-up" condition occurs where the gate loses any capability of switching the device into the "off" condition after a substantial current flow has been established therethrough. Such a "latch-up" condition occurs because of feedback actions in the current flows in the four layers, a situation usually modeled by an equivalent circuit having a pnp bipolar transistor and a npn bipolar transistor interconnected to one another in a feedback configuration. The collector of one is connected to the base of the other, the emitters of each forming the device terminating regions which, in the device of Figure 2, are those connected to terminals 15 and 17.

In the device of Figure 1, the "latch-up" condition is prevented by having terminal 15 serve as a short between n⁺-type conductivity region 13, serving as the emitter of the circuit model npn bipolar transistor, and regions 14 and 12, serving as the base of this npn bipolar transistor in the equivalent circuit model. This keeps current gains sufficiently low that sustained feedback activity in the current flows cannot be maintained.

Nevertheless, the Figure 2 device operating condition rather closely approaches a "latch-up" condition for sufficient current being drawn through the MOSFET portion inherent in the structure with terminal 17 at a positive voltage, this inherent MOSFET being formed by regions 11 and 13, serving as the source and drain regions respectively, about the channel formed by region 12 under gate 18. This MOSFET draws sufficient current from region 11, serving as the base of the circuit model pnp bipolar transistor, to switch this transistor strongly into the "on" condition. Gate 18 stays fully in control of the current being carried between terminals 17 and 15 through setting the value thereof by the value of the gate voltage, over a wide range of operating conditions, so that the initiation and ceasing of the flows of such currents can be determined by applying the proper voltage to gate 18. Thus, the device of Figure 2 has a lower "on" resistance because of the pnp transistor being saturated, and yet the device can be fully controlled even after substantial current begins flowing therethrough by voltages applied to gate 18 because a "latch-up" condition is prevented from occurring by the base-emitter junction of npn circuit model transistor being shorted by terminal 15.

A further advantage flows from substituting p⁺-type conductivity semiconductor material as substrate 10' in Figure 2 for the n⁺-type conductivity material serving as substrate 10 in Figure 1. That is, there is now the ability to block voltages between each of terminals 15 and 17, whatever the polarity, if gate 18 has placed the device in the "off" condition insofar as current flows between terminals. This is because of the semiconductor pn junction resulting between regions 10' and 11 which will be under a reverse bias voltage for a positive voltage at terminal 15 with respect to terminal 17. As a result, two of these devices can be connected in parallel with terminal 15 of one being connected to terminal 17 of the other to thereby provide a bilateral switching arrangement which can control current flows in either direction through this combination.

Thus, the device of Figure 2 represents an improvement in reducing the "on" resistance to current flows therethrough between terminals 17 and 15 while retaining full capability to initiate and stop such flows at gate 18. In addition, voltages of either polarity can be blocked insofar as causing any current flow between terminals 17 and 15 in either direction if gate 18 has thereon voltages such as to maintain the device in the "off" condition. On the other hand, the device of Figure 2 is still a vertical device in having the primary current flow terminals located on opposite sides of the semiconductor material provided therein.

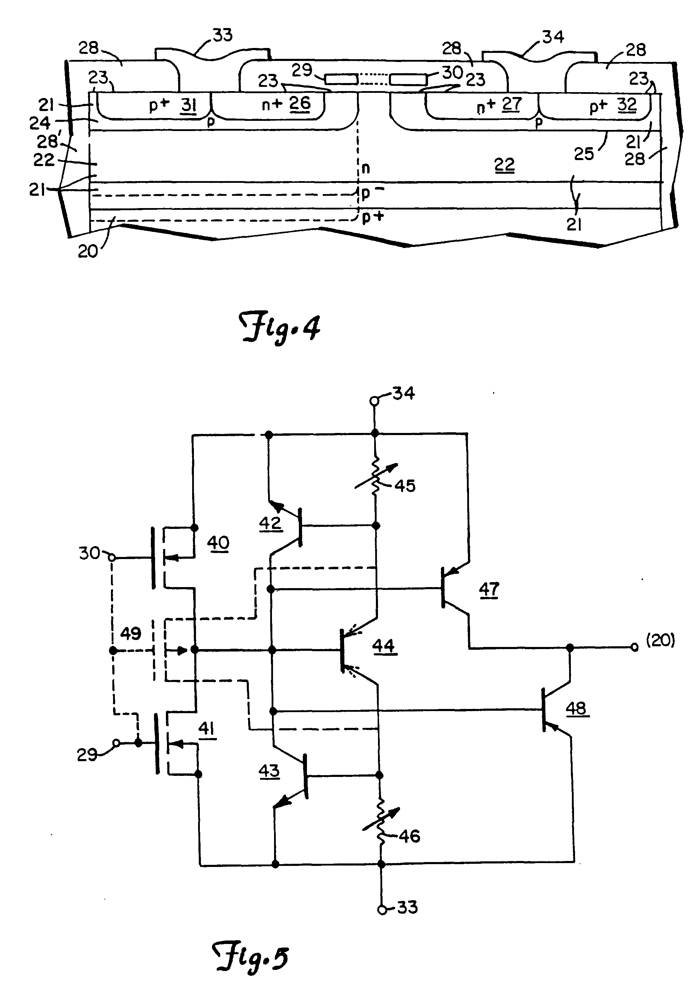

This situation has been sought to be remedied by forming a lateral conductivity modulated field-effect transistor or insulated gate transistor, as shown in Figure 3. Regions having a similar function in Figure 3 retain the same designations as they had in Figures 1 and 2, such as regions 12, 13 and 14. Terminal 15 is again shorting together regions 13 and 14. Region 11 of Figure 2 has become the entire substrate in Figure 3 and so is redesignated 11'. The conductivity type region that had been substrate 10' in Figure 2 has now been moved to the same major surface of the semiconductor material body to which terminal 15 is connected and so has been redesignated 10" in Figure 3. This region is connected by a terminal region at the major surface of the semiconductor material body and so is redesignated 17'.

The operation of this device is essentially that described for Figure 2, and so this device has provided a solution to many of the difficulties which plague the device of Figure 1. Nevertheless, the devices of Figures 2 and 3, though having a lower "on" resistance than the device of Figure 1, still have an "on" resistance which is greater than that of a thyristor device "latched-up" in the "on" condition. Therefore, there remains a desire for a lateral current controlling device for monolithic integrated circuit chips having a relatively lower "on" resistance.

US Patent 4,199,774 describes a bilateral switching device which can be triggered into a triac operation. Once triggered into a triac type conduction, the switching device can only be returned to a non-conductive state by shorting out the base-emitter junction of one of the transistors, or by removing the supply voltage or current.

IEEE Electron Device Letters EDL-7 (1986) Feb No. 2 pages 61-63 discuss a semiconductor switching device using a lateral MOS device, with increased immunity to latchup.

IEEE Transactions on Electron devices Vol. ED 27 No. 2, Feb 1980, pages 380-387 describes a bilateral switching device being an insulated gate controlled planar thyristor. Once latched on, the device can only be turned off by removing the supply voltage or current, or by short circuiting the base-emitter junction of one of the transistors.

### SUMMARY OF THE INVENTION

The present invention provides a bilateral switching device as recited in claim 1. Specific embodiments of the device of the present invention are recited in dependent claims 2-13.

### BRIEF DESCRIPTION OF THE DRAWINGS

Figure 1 shows a representation of a field-effect transistor device known in the prior art,
Figure 2 shows a representation of a device also known in the prior art which is a modification of the device of Figure 1,
Figure 3 shows a representation of a device also known in the prior art which is a modification of the device of Figure 2,
Figure 4 shows a representation of the device of the present invention,
Figure 5 shows an equivalent circuit schematic diagram of the device of Figure 4,
Figure 6 shows a layout of the device shown in Figure 4, and
Figure 7 shows a layout for a device which combines multiples of the device of Figure 4.

### DETAILED DESCRIPTION OF THE PREFERRED EMBODIMENTS

A device that is bilateral through having four or more alternating conductivity type semiconductor layers between its terminals with its primary terminating regions at a common surface of the semiconductor material body in which it is formed, and at which it exhibits symmetrical bidirectional current flow and blocking voltage capabilities, is shown in Figure 4. The device shown is typically formed of doped silicon having boron distributed therein to provide a substrate, 20, of a p⁺-type conductivity material having a resistivity of 0.2 Ω - cm and with its upper major surface shown located in the (100) crystal plane of the silicon. A p⁻-type conductivity boron doped silicon epitaxial layer, 21, is usually grown thereon in this embodiment having resistivity of 1 to 5 Ω-cm. A n-type conductivity region, 22, is typically provided in epitaxial layer 21 through ion implanting of phosphorous ions at a dose of 3 x 10¹² ions/cm² at an energy of 150 Kev, which results in a semiconductor pn junction between region 22 and remaining portions of layer 21 at a depth of 2 to 3 µm below the upper surface of layer 21.

Region 22 intersects the semiconductor material body major surface, 23, at the upper surface of layer 21, and has selected p-type conductivity regions, 24 and 25, therein which also intersect major surface 23. Regions 24 and 25 are usually formed essentially identical to one another, including the depth of the pn junctions separating them from remaining portions of region 22 which at their deepest points, is approximately 0.5 µm. They are typically each formed simultaneously by ion implanting boron ions in a dose of 8 x 10¹² ions/cm² at an energy of 60 Kev. Regions 24 and 25 are separated from one another in surface 23 at the semiconductor pn junction separating each from the remaining portions of region 22 by approximately 3 to 5 µm.

Each of regions 24 and 25 has a n⁺-type conductivity region interior thereto typically formed by ion implantation of phosphorous or arsenic ions into regions 24 and 25 using a dose of 2.5 x 10¹⁵ ions/cm² at an energy of 80 Kev for arsenic. This results in a semiconductor pn junction separating each such region from its corresponding one of regions 24 and 25 each having its greatest depth at 0.3 µm below major surface 23. These regions, 26 and 27, also intersect major surface 23 of the semiconductor material body, and there is a difference in the lateral position along surface 23 of (i) the semiconductor pn junctions separating each of regions 24 and 25 from the remaining portions of region 22, and (ii) the semiconductor pn junctions separating each of regions 26 and 27 from regions 24 and 25, respectively. These lateral position differences in corresponding ones of these junctions leave regions 26 and 27 separated from remaining portions of region 22 outside regions 24 and 25. This results in a separation space typically of 1 to 3µm in both major surface 23 and region 24 between the edge of region 26 formed by the semiconductor pn junction between regions 24 and 26, and the edge of region 24, formed by the semiconductor pn junction between region 24 and 22. Similarly, there is a separation space in both major surface 23 of a similar extent located in region 25 between the edge of region 27, formed by the semiconductor pn junction separating regions 27 and 25, and the edge of region 27 formed by the semiconductor pn junction between region 25 and other portions of region 22.

Each of these separating spaces has across' portions of an electrically insulating layer, 28, formed primarily of silicon dioxide, a gate region, these being designated 29 and 30 in Figure 4. These are each typically formed of polysilicon which has been doped with phosporus to the extent of 10¹⁹ atoms/cm³ to provide a resistivity of 0.01 Ω -cm. Gate regions 29 and 30 are typically separated from major surface 23 by portions of layer 18 having a thickness of 30ₙₘ (300 Å).

Regions 24 and 25 each have a further p⁺-type conductivity connection region established therein adjacent to interior regions 26 and 27, these connection regions being typically formed by ion implantation with a dose of 5x10¹⁴ ions/cm² at an energy of 100 Kev to thereby reach a depth below surface 23 of approximately 0.4 µm. Regions 31 and 32, are chosen to be of a higher conductivity than other portions of regions 24 and 25, respectively, for purposes of making an ohmic contact thereto.

Such ohmic contacts are usually provided by metal deposition interconnection network contacts, 33 and 34, with metal primarily being copper (4%) alloyed aluminum. Terminal 33 connects the interconnection network with an ohmic contact to both of regions 31 and 26, short circuiting or directly connecting these two regions together, and thereby provides a terminating region for the device of Figure 4 comprising those portions with which terminal 33 is in contact. Similarly, terminal 34 places portions of the interconnection network in ohmic contact with both regions 32 and 27 to provide a short circuit or direct connection therebetween, and to form portions of each, those in ohmic contact with terminal 34, into another terminating region for the device of Figure 4. None of the remaining portions of the interconnection network are shown in this figure.

Electrical insulating oxide 28 is shown having extensions on the right and on the left in Figure 4 downward into the semiconductor material body below major surface 23. These extensions, designated 28' in Figure 4, serve to provide "oxide isolation" or electrical isolation for the device of Figure 4. This is necessary in the arrangement shown in Figure 4 in which both p-type conductivity semiconductor material and n-type conductivity semiconductor material are shown adjacent to the isolation regions in which extensions 28' occur. This use of oxide isolation could be replaced by using junction isolation regions if, for instance, region 22 was chosen to surround regions 24 and 25 below major surface 23.

The structure shown in Figure 4 can readily be made in a fabrication process which also provides bipolar transistors in monolithic integrated circuits fabricated primarily on the basis of complementary metal-oxide-semiconductor (CMOS) technology in which the primary active elements are formed by pairs of n-channel and p-channel MOSFET's. Thus, region 22 would be formed by the "n-well" in which p-channel MOSFET's would be fabricated (the n-channel MOSFET's being fabricated directly in epitaxial layer 21 at locations where implantation formed region 22 has not been provided). Regions 24 and 25 would be formed simultaneously with the formation of bases for the vertical npn bipolar transistors. Regions 26 and 27 would be formed simultaneously with emitters for the vertical npn bipolar transistors and with sources and drains for the n-channel MOSFET's. Regions 31 and 32 would be formed simultaneously with the interconnection portions of bases for the npn bipolar transistors and with sources and drains of the p-channel MOSFET's.

In Figure 4, the restricting of penetration of the implanted ions in the ion implantation step used in forming region 22 is done so that the remaining portion of epitaxial layer 21 retains its initial p⁻-type conductivity. This is done to increase the breakdown voltage between region 22 and the remaining portion of region 21 thereby not converted to n-type conductivity located adjacent to substrate 20. If this higher breakdown voltage is not necessary, region 22 could extend down to region 20. Alternatively, if this device need not necessarily to be compatible with CMOS technology, the entire substrate could be formed of p⁻-type conductivity so that no epitaxial layer need be provided. The presence of a p⁻-type conductivity portion adjacent region 22 also reduces junction capacitance thereby increasing the switching speed of the device in the current switching operation to be described below.

This switching operation is more easily understood if the equivalent circuit model for the device of Figure 4, shown in Figure 5, is used as part of the description. Each of gates 29 and 30 are part of an equivalent n-channel MOSFET shown in Figure 5, these two MOSFET's being connected in series with one another between terminals 33 and 34 in Figure 4. Each of these MOSFET's is shown to be of the DMOS type (though need not be, but if used gives a short channel for these MOSFETS), having a channel region thereof electrically connected to a terminating region of the MOSFET which serves as a source.

One MOSFET in Figure 5, 40, having gate 30 associated therewith, is formed of n⁺-type conductivity region 27 as one terminating region thereof, and n-type conductivity region 22 as the other terminating region thereof. The channel region is formed by p-channel conductivity region 25 and p⁺-type conductivity region 32 which together are directly connected by terminal 34 to region 27.

The remaining MOSFET in Figure 5, 41, having gate 29 as a portion thereof, is formed with one of its terminating regions being provided by n⁺-type conductivity region 26 and the other again by n-type conductivity region 22. The channel region for this MOSFET is formed by p-channel conductivity region 24 and p⁺-type conductivity region 31, these two regions being directly connected by terminal 33 to region 26. Thus, the substrate or channel regions for each of these MOSFET's is directly connected to a corresponding one of terminals 33 and 34.

The structure of Figure 4 also provides several effective bipolar transistors. A npn bipolar transistor, 42, is shown in Figure 5. One of the terminating regions for this bipolar transistor, serving as its emitter, is formed by n⁺-type conductivity region 27, and the collector is formed by n-type conductivity region 22. The base for transistor 42 is formed by p-type conductivity region 25. Thus, this is a vertical npn bipolar transistor in the structure of Figure 4.

Similarly, another npn bipolar transistor shown in Figure 5. The emitter region of this bipolar transistor will be formed by n⁺-type conductivity region 26 and the collector will be formed by n-type conductivity region 22. The base for transistor 43 is formed by p-type conductivity region 24. Transistor 43 is also a vertical npn bipolar transistor in the structure of Figure 4. Note that lateral npn bipolar transistors are, in addition, formed near surface 23 by these regions forming vertical transistors 42 and 43. These will have little effect since they are of a very low current gain because the base regions thereof beneath gates 29 and 30 are relatively wide.

A lateral pnp bipolar transistor in Figure 5, 44, is also formed in the structure of Figure 4 from the common terminating region of bipolar transistors 42 and 43, that being n-type conductivity region 22, and from the base regions of each of transistors 42 and 43. That is, transistor 44 in Figure 5 has region 22 in Figure 4 as its base region, and has p-type conductivity regions 24 and 25 in that figure as the terminating regions of this bipolar transistor if these two regions are sufficiently close to one another to provide bipolar transistor action. Regions 24 and 25 will serve as either an emitter or a collector for transistor 44 depending on the polarities of the voltages applied between terminals 33 and 34. Again, this is reflected in Figure 5 by having emitter arrows in dashed lines present on each of the terminating region leads emanating from transistor 44.

These terminating region leads from transistor 44 are shown in Figure 5 each going to a resistor which in turn is connected to a corresponding one of terminals 33 and 34. This occurs since the terminating regions for transistor 44, as formed by regions 24 and 25, are effective, at least initially, primarily near the separating spaces in regions 24 and 25 included in major surface 23. However, terminating regions for transistor 44 are electrically connected to terminals 33 and 34 through regions 31 and 32, respectively, near those sides of regions 26 and 27, respectively, which are opposite those sides of regions 26 and 27 adjacent to these separating spaces. Thus, there is a relatively long current flow path through regions 24 and 25 and then through regions 31 and 32, respectively, before terminals 33 and 34 are reached by currents flowing in regions 24 and 25 near the separating spaces. These long current paths provide a significant amount of electrical resistance to current flows, and so the current flow paths in regions 24 and 25 are each represented in Figure 5 by a resistor.

These are shown as variable resistors because the resistance values depend on current flow conditions in these regions. The high resistance current path in region 25 going from near the separating space therein occurring in major surface 23 to terminal 34 (the low resistance path will be described below in connection with the description of operation) comprises the distance along region 27 and through region 32 to terminal 34 to form one Figure 5 variable resistor, 45, in its high resistance variation. The high resistance current path in region 24 from near the separating space therein included in major surface 23 is along region 26 and through region 31 to terminal 33 to form the remaining Figure 5 variable resistor, 46, in its high resistance variation.

Since substrate 20 in Figure 4 will have an electrical terminal means connected thereto for connection to an external voltage source, two further vertical pnp bipolar transistors must be added to the circuit of Figure 5 for it to be an equivalent circuit model for the device of Figure 4. The first of these pnp bipolar transistors, 47, has its emitter formed by p-type conductivity region 25, its base formed by n-type conductivity region 22, and its collector formed by the remaining p⁻-type conductivity portion of layer 21 together with p⁺-type conductivity substrate 20. The external connection to substrate 20 is indicated in Figure 5 by (20) near this substrate terminal. The remaining pnp bipolar transistor, 48, has its emitter formed by p-type conductivity region 24, its base formed by n-type conductivity region 22, and its collector formed by the remaining p⁻-type conductivity portion of layer 21 together with p⁺-type conductivity substrate 20.

As a basis for describing the operation of the structure of Figure 4 and the equivalent circuit of Figure 5, assume substrate 20 to be connected to a ground reference voltage. Since the device is bilateral in operation, the description for positive voltage at terminal 34 (usually applied through a load device) with terminal 33 also connected to a ground reference would be identical to the description which would be provided for reversing these connections of terminals 33 and 34. Initially, at least, consider terminal 30 as also being connected to the ground reference potential.

A control voltage signal is applied to terminal 29 in Figures 4 and 5. As this voltage is increased past the threshold voltage of MOSFET 41, MOSFET 41 switches into the "on" condition and injects electrons into the terminating region thereof connected to MOSFET 40 in Figure 5, i.e. into n-type conductivity region 22 of Figure 4. These electrons lower the potential of region 22 to forward bias the semiconductor pn junction between region 22 and p-type conductivity region 25. In this way, a current flow (due to electron flow) is provided through MOSFET 41 from the base of lateral pnp transistor 44 to terminal 33 at ground reference potential. Similarly, a current path is provided from the base of transistor 47 through MOSFET 41 to terminal 33. As a result, holes are injected into region 22. Part of the injected holes are collected by substrate 20 serving as the collector of vertical transistor 47, and the remaining part of these injected holes are collected by p-type conductivity region 24 serving as the collector of lateral transistor 44. Region 24 also serves as resistor 46 in the base of transistor 43. That is, bipolar transistors 44 and 47 begin to switch into the "on" condition.

The current provided by bipolar transistor 44, in the form of holes being injected into region 24, flows through resistor 46, as indicated, and out terminal 33. The current causes a voltage drop across region 24, i.e. resistor 46, as currents flow along region 24 past and under n⁺-type conductivity region 26 and into p⁺-type conductivity region 31 to terminal 33 in Figure 4. In these circumstances, the high resistance value for resistor 46 is encountered by this current flow, and this voltage drop quicky grows to exceed the threshold value of the emitter-base junction of transistor 43.

As this occurs, the current being supplied by bipolar transistor 44, beyond that needed to raise the voltage drop across resistor 46 to this threshold value, will be shunted into the base of transistor 43 and across the forward biased semiconductor pn junction separating region 24 from region 26 in Figure 4, i.e. into the base and out the emitter of bipolar transistor 43. The result is that transistor 43 begins to switch into the "on" condition drawing further current from the base of transistor 44 which in turn supplies further current to the base of transistor 43 so that a regenerative process ensues. Transistors 43 and 44 will go into "latch-up" operation as a result of this regenerative process if the effective common base current gains of each summed together exceed the value 1 as is well known in transistor and four layer device theory.

The common base current gain of transistor 43 will itself be increased by the additional current supplied to the base thereof as the voltage across resistor 46 exceeds the threshold value of the base-emitter junction of that transistor as is well known in semiconductor device theory. The common base current gain of transistor 44 is also increased by the current drawn out of its base from MOSFET 41. Thus, the common base current gains of transistors 43 and 44 will increase until their sum equals 1 so that transistors 43 and 44 together then go into the "latch-up" condition, each forcing base current from the other to thereby switch that other strongly into the "on" condition.

At this point, this "latch-up" condition will continue so long as MOSFET 41 continues to draw current from the base of transistor 44 to keep its common base current gain sufficiently large. In these circumstances, the current flowing from terminal 34 through resistor 45 and then through transistors 44 and 43 and out terminal 33 will take on values which are independent of the voltage applied to gate 29 of MOSFET 41. That is, the current flow will be determined by the external load device connected between terminal 34 and the positive voltage supply. A termination of this current flow will, of course, allow transistors 43 and 44 to come out of the "latch-up" condition.

However, this is not the only control over the continuation of the "latch-up" condition in transistors 43 and 44 - switching MOSFET 41 into the "off" condition so that it does not continue to draw current from bipolar transistor 44 will have the same effect of terminating the "latch-up" condition of transistors 43 and 44. Thus, control of current flows between terminals 34 and 33 through transistors 43 and 44 is maintained, in the switching on and off sense, by the voltage at gate 29 of MOSFET 41 insofar as this current flow can be permitted, or terminated if flowing, by the choice of value for the voltage applied at gate 29.

The voltage drop which occurs between terminals 34 and 33, if the device of Figure 4 is switched into the "on" condition by the voltage applied at gate 29, is determined by the voltage drop across transistors 44 and 43 in the "latch-up" condition and the voltage drop across resistor 45. The voltage drop across transistors 43 and 44 in the "latch-up" condition will be lower than the voltage drop across the devices shown in Figures 2 and 3 in comparable circumstances, because the "latch-up" condition is actively prevented in those devices because of the shorting of regions 13 and 14 together therein by terminal 15, as described above, which is done to avoid the occurrance of a "latch-up" condition. Allowing transistors 43 and 44 to go into the "latch-up" condition allows each of them to force the other much further into the "on" condition (thereby lowering the "on" resistance across them significantly) than can the npn and pnp bipolar transistor equivalents for the devices of Figures 2 and 3 which are prevented from going into the "latch-up" condition. Thus, the voltage drop across transistors 43 and 44 in the "latch-up" condition will be quite low because of this relatively low "on" resistance.

However, if the resistance value of resistor 45 was the high value taken by resistor 46 in the present conditions, there would be a very substantial voltage drop across resistor 45 for significant currents flowing therethrough leading to a relatively high voltage drop across the device of Figure 4. Happily, that is not the situation for resistor 45 because in these circumstances the resistance value of resistor 45 will be at its low rather than at the high value taken by resistor 46 in these conditions. That is, the current path for currents entering terminal 34, and so regions 32 and 25, will be spread across a large portion of the forward biased semiconductor pn junction separating region 25 from region 22, and will flow particularly across the portion of that junction near region 32 because that portion will be more strongly forward biased than other portions. Thus, there is a relatively short path and correspondingly low resistance through region 25 to region 22 for these substantial currents to flow. Furthermore, there are many paths because, as stated, much of the junction will carry this current flow thereacross, which in effect provides many parallel paths to thereby further reduce this resistance value which effectively is taken by resistor 45.

In contrast, bipolar transistor 44, in being switched into the "on" condition as described above, has the currents therethrough initially flowing from the portion of region 25 under gate 30, then through region 22 to the portion of region 24 under gate 29. As a result, this current, to reach terminal 33, must take the longer current path through region 24 along region 26 and into region 31 so that this initial current flow encounters the higher resistance condition in region 24, i.e. resistor 46 is in the higher resistance condition while resistor 45 is in the lower resistance condition. As a result of resistor 45 being effectively in the lower resistance value condition, the "on" condition voltage drop, and the "on" resistance value, are both kept relatively low for the device of Figure 4.

Thus, the proper geometrical construction and doping concentration levels for regions 24 and 25 are important to the proper operation of the device of Figure 4. If the current path in the maximum resistance situation is too long, or has too great a resistivity, such that the effect of resistance value of resistor 46 is too large, there will be little difficulty in switching the device to the "on" condition so that transistors 43 and 44 go into the "latch-up" condition, but there will be substantial difficulty in assuring that switching MOSFET 41 to the "off" condition will lead to a termination of this "latch-up" condition. On the other hand, if the resistance value for resistor 46 is too small, there may not be sufficient current drawn by MOSFET 41, and so supplied by bipolar transistor 44, to switch transistor 43 into the "on" condition. The resistance values of regions 24 and 25 are controlled in the same way that a "pinch" resistor is controlled in that the doping level of regions 24 and 25, and the extent of regions 26 and 27 therein, respectively, control the effective resistance values.

There is a further factor in assuring that transistors 43 and 44 can be placed in the "latch-up" condition. That factor is the amount of current shunted from terminal 34 by pnp transistor 47 to substrate terminal 20 in Figure 5. To the extent that the gain of transistor 47 (and transistor 48 for reversed voltage polarity on terminals 33 and 34) can be lowered, the more current will be available through bipolar transistor 44 to switch bipolar transistor 43 into the "on" condition.

One way to lower the gain of bipolar transistors 47 and 48 would be to replace the remaining p⁻-type conductivity portion of layer 21 in Figure 4 with a n⁺-type conductivity "buried layer" region. While this does reduce the gain of either of transistors 47 and 48, there is a penalty in that the breakdown voltage between terminals 33 and 34 and substrate terminal 20 is also reduced.

Another condition required to assure that transistors 43 and 44 can be placed into the "latch-up" condition is that sufficient current is drawn by MOSFET 41 from the base of transistor 44. This requires that MOSFET 41, and MOSFET 40 if symmetrical operation is to be maintained, be designed with sufficient width to length ratios to assure that each can sink an adequate amount of current for this purpose. Since the length parameter for these MOSFET's is fixed to a certain extent by the minimum structural feature size permitted by the lithography steps used in fabricating the structure of Figure 4, the primary variable which can be controlled in the width to length ratio requirement is the width of the channel in and out of the plane of the paper of Figure 4 under gates 29 and 30.

The operation description was given with gate 30 connected to ground. This assured that MOSFET 40 was in the "off" condition during the sequence of operation described and would not be a factor in that operation. However, a much more convenient possibility exists for controlling the device of Figure 4 which is suggested by the dashed lines shown between gates 29 and 30 therein. That is, gates 29 and 30 can be a single gate structure (designated 29,30) extending from the left-hand edge of gate 29 to the right-hand edge of gate 30 in Figure 4. This has the effect of electrically connecting gate 30 to gate 29 for purposes of the above description rather than connecting it to ground.

Before a positive control voltage is applied to gate structure 29,30 in operation, both will be in the "off" condition for positive voltage connected through a load to terminal 34 with terminal 33 connected to the ground reference voltage. After a positive voltage is supplied to gate 29 which reaches a value sufficient to place the structure of Figure 4 in the "on" condition, by having transistors 43 and 44 placed in the "latch-up" condition, both MOSFET's 40 and 41 will be in the "on" condition with the "on" condition voltage between terminals 34 and 33 applied across these MOSFET's in series. These MOSFET's, in the "on" condition, thus further lower the "on" resistance of the device of Figure 4 in the "on" condition by being in parallel with the current path through transistors 43 and 44. The combining of gates 29 and 30 into a single structure also provides a simpler connection requirement for the control signals to be used in controlling the device of Figure 4.

A further advantage comes because the forming of a single gate structure 29,30 from the left-hand edge of gate 29 to the right-hand edge of gate 30 yields a further p-channel MOSFET, 49, being provided, which is shown in the equivalent circuit of Figure 5 in dashed lines corresponding to the dashed lines indicating a single gate structure for gates 29 and 30 in Figure 4. The terminating regions of transistor 49 are formed by the p-type conductivity regions 24 and 25 in Figure 4 near the separating spaces under gates 29 and 30, respectively, and the channel region is formed by n-type conductivity region 22. The single gate structure 29,30 formed from the left-hand edge of gate 29 to the right-hand edge of gate 30 serves as a gate for MOSFET 49.

The presence of MOSFET 49 permits switching the device of Figure 4 into the "on" condition with the use of a voltage control signal on the combined gate structure 29,30 which is negative with respect to the ground reference voltage provided at terminal 33. That is, a negative voltage control signal on combined gate structure 29,30, which is in excess of the threshold voltage of transistor 49, will switch transistor 49 into the "on" condition drawing current through resistor 45 and conducting same into resistor 46 to begin the placing of transistors 43 and 44 into the "latch-up" condition. This current can be made sufficient to raise the common base current gain of transistor 43 so that the sum of the common base current gains of both transistors 43 and 44 will exceed one to permit "latch-up" to occur.

Again, for a reversal of voltage polarity between terminals 34 and 33, the same description of the operation of the structure of Figure 4 and the circuit of Figure 5 can be given since the combining of gates 29 and 30 into a single combined gate structure 29,30 does not change the symmetry of the device in Figure 4. Hence, the structure in Figure 4 can control alternating polarity voltages provided to one of terminals 33 and 34 with respect to the other, can control current in each direction flowing between these terminals, and can use either a positive voltage or negative voltage control signal to do so.

The structure of Figure 4 is shown entirely symmetrical. However, there need not be such symmetry even though still having a device which is capable of controlling currents in either direction between terminals 33 and 34. One alternative is to have p-type conductivity region 24 extend through n-type conductivity region 22 all the way into the remaining p⁻-type conductivity portion of layer 21, or even further to substrate 20. Alternatively, p⁻-type conductivity region remaining portion 21 could be eliminated altogether so that region 22, although perhaps with a reduced conductivity to the point of being an n⁻-type conductivity region, is directly against substrate 20 with region 24 again extending thereto. Such an extension is indicated in Figure 4 by the alternating short and long dashed line indicating this extension of region 24 into the remaining p⁻-type conductivity portion of layer 21, or alternatively a further such dashed line indicating an extension all the way to substrate 20.

In the situation where terminal 34 is positive with respect to terminal 33, the increased size of region 24 will reduce the resistance occurring therein and so occurring in the base region of the equivalent npn bipolar transistor of which it is a part. On the other hand, a larger current will be available thereto since the current to substrate 20 from terminal 34 will now be collected in this same region 24 by virtue of its being electrically in a common region with substrate 20 due to its intersection therewith. This will provide additional design freedom in adjusting the voltage which must be applied at gate 29 to cause this structure in Figure 4 to switch into the "on" condition.

For a reversal in the voltage polarities on terminals 33 and 34, the structure would again have the higher value of base resistance for the current path in region 25, but the transistor from terminal 33 is eliminated so again there is not the current loss from this terminal by transistor action though there will be a base resistive current loss to the substrate terminal. Thus, there is again an opportunity to select the value for the voltage applied to gate 30 which switches this version of the device of Figure 4 into the "on" condition, a value which can differ from that selected for gate 29.

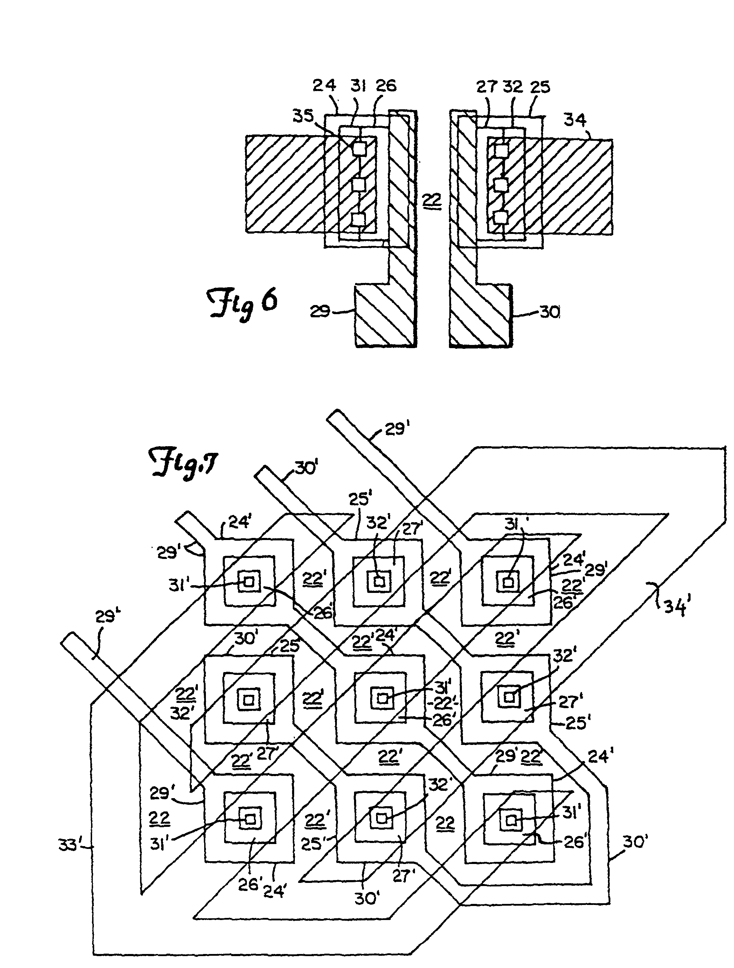

Figure 6 shows a layout for the device of Figure 4 below and on major surface 23, this being a view looking downward onto Figure 4. As indicated above, the structure shown in Figure 4 and in Figure 6 is shown without a final passivation layer thereover, and further, the metal interconnection system portions leading from terminals 33 and 34 are not shown at all in Figure 4 although they are to some extent in Figure 6. There is also no use in Figure 6 of dashed lines to indicate structural features which are covered or hidden by other structural features. Further, these figures are not necessarily drawn to scale or have their features in actual proportion to one another, rather, they are representational for aiding the reader in understanding what is occurring as opposed to providing geometrically accurate drawings.

The designations used for the device structural features in Figure 4 have been continued in Figure 6 for the same structural features. In addition, shading has been used to distinguish structural features from one another. The complete symmetry of the device of Figure 4 can be seen clearly in Figure 6.

The "on" resistance of the device of Figures 4 and 6 can be significantly reduced by providing multiple Figures 4 and 6 structures to increase the number of current paths in parallel. Such an arrangement is shown in Figure 7. The structures are designated in Figure 7 with numerals used in connection with Figures 4 and 6 but with prime marks added to indicate that the designated structures represent adaptations from the structures of Figures 4 and 6 to the arrangement of Figure 7.

A serpentine interconnected collection of hollow rectangles is marked 30', and each such rectangle corresponds to a gate 30 over a similar rectangle of p-type conductivity material 24 in Figure 4, but together serving as regions 25'. A similar statement is true for those hollow rectangle structures marked 29' (which would be connected together in a finished diagram) each of which represents a gate over a similarly shaped p-type portion of semiconductor material serving as regions 24'.

Each of the regions of p-type semiconductor material 25' covered by a portion of gate 30' surrounds a n⁺-type conductivity region 27' which in turn surrounds a p⁺-type conductivity region 32'. Similarly, each p-type conductivity region 24' under hollow rectangle portion of gate structure 29' surrounds a n⁺-type conductivity region 26' which in turn surrounds a p⁺-type conductivity region 31'. Those regions 26' and 31', associated with gate structure 29', are electrically interconnected by a metalization structure 33' which shorts each region 31' to each region 26'. Another metalization structure 34' electrically interconnects and shorts each region 32' to each region 27'.

As can be seen from this arrangement of Figure 7, an arrangement which can be laterally extended indefinitely to provide as low an "on" resistance as desired subject to the constraint of the size of the monolithic integrated circuit chip, each terminal connection point to one of interconnection arrangements 33' or 34' is in practice surrounded by neighboring interconnection points made to the other interconnection arrangement. Thus, a region 24' under a hollow rectangular gate structure 29' has on each side thereof, across a region of n-type conductivity material 22', a neighboring p-type conductivity structure 25'. The interaction in the structure of Figure 7 between (i) such a structure 24', and the n⁺-type conductivity region 26' interior thereto surrounding a p⁺-type conductivity region 31', on the one hand, and (ii) the neighboring p-type conductivity regions 25', and the n⁺-type conductivity region 27' interior thereto surrounding a p⁺-type conductivity region 32', is essentially the same as the interaction of the structure in Figure 4 between (a) region 24, and in region 26 interior thereto adjacent to region 31, and (b) region 25, including region 27 interior thereto and adjacent region 32. Since, as indicated above, this arrangement could be spread indefinitely, the additional current paths due to these interactions between an interconnection point and its nearest neighbors clearly will provide additional current paths in parallel to thereby effectively reduce the "on" resistance of the device of Figure 7.

Although the present invention has been described with reference to preferred embodiments, workers skilled in the art will recognize that changes may be made in form and detail without departing from the spirit and scope of the invention.

Advantageous additional features which may be included alone or in any appropriate combination in the present invention include: said plurality of characteristic regions is located at an intersection of a mesh pattern in said first major surface portion; said mesh pattern follows a mesh pattern of orthogonal lines; a second interconnection termination means is electrically connected to those said portions of said second interior region and said second contact portion forming said second terminating region as aforesaid; said second contact portion at least partly surrounds said second interior region in said first major surface portion; said semiconductor material body portions of said first conductivity type at least partly surround said first characteristic region in said first major surface portion; a first interconnection termination means is electrically connected to those said portions of said first interior region and said first contact portion forming said first terminating region as aforesaid; said second contact portion is at least partly surrounded by said second interior region in said first major surface portion; said semiconductor material body portions of said first conductivity type at least partly surround said second characteristic region in said first major surface portion; a first interconnection termination means is electrically connected to those said portions of said first interior region and said first contact portion forming said first terminating region as aforesaid; said semiconductor material body portions of said first conductivity type entirely surround said first characteristic region in said first major surface portion; a second interconnection termination means is electrically connected to those said portions of said second interior region and said second contact portion forming said second terminting region as aforesaid; said first terminating region includes at least a portion of said first contact portion; said semiconductor material body portions of said first conductivity type entirely surround said second characteristic region in said first major surface portion; a second interconnection termination means is electrically connected to those said portions of said second interior region and said second contact portion forming said second terminating region as aforesaid; said first terminating region includes at least a portion of said first contact portion; said second terminating region includes at least a portion of said second contact portion; said second terminating region includes at least a portion of said second contact portion.

## Claims

1. A semiconductor bilateral switching device **characterised by** having a gate electrode (29,30) and first (beneath 33) and second (beneath 34) terminating regions each of which can serve as an anode and a cathode thereof, said switching device being capable of conducting, as a main current flowing through it, a load current flowing between said first and second terminating regions, said device comprising:
a semiconductor material body having a first major surface (23) and comprising a device region (22) of a first conductivity type, eg. n, and a first conductivity, intersecting said major surface (23);
a plurality of intermediate regions (24,25) intersecting said first major surface (23) in a first major surface portion including first (24) and second (25) intermediate regions which are spaced apart from one another in said device region (22) and thus spaced apart in said first major surface portion, each of said intermediate regions being of a second conductivity type, eg. p, to result in each forming a corresponding intermediate pn junction with said device region, a portion of which junction being on a side of its associated intermediate region that is opposite said first major surface portion;
a plurality of contact regions (31,32), each intersecting said first major surface portion, including first (31) and second (32) contact regions with each of said contact regions being located in a corresponding one of said intermediate regions but of a greater conductivity, eg. p+, than remaining portions of its corresponding said intermediate region, said first contact region (31) being in said first intermediate region (24) and said second contact region (32) being in said second intermediate region (25); and
a plurality of interior regions (26, 27), each intersecting said first major surface portion, including first (26) and second (27) interior regions, with each of said interior regions being located in a corresponding one of said intermediate regions, surrounded by said corresponding intermediate region and spaced apart from said device region by its corresponding intermediate region to form a corresponding interior pn junction with its corresponding intermediate region, intersecting said first major surface portion and separated from its corresponding said intermediate pn junction to provide a resistive portion of that intermediate region located along said interior region between a portion of said interior pn junction and said portion of its corresponding intermediate pn junction and a separating space between said interior pn junction and its corresponding intermediate pn junction at said major surface portion, said first interior region (26) being within said first intermediate region (24) and said second interior region (23) being within said second intermediate region (25), said plurality of interior regions each being of said first conductivity type with said first terminating region including at least portions of said first interior region (26) and said first contact region (31) and with said second terminating region including at least portions of said second interior region (27) and
said second contact region (32);
a first interconnection termination means (33) electrically connected to the first terminating region, and a second interconnection termination means (34) electrically connected to the second terminating region;
the contact regions having portions adjacent the sides of the interior regions which are opposite the sides of the interior regions adjacent the separating spaces, and the first and second terminating regions include at least said portions of the first and second contact regions, respectively, which are contacted by the respective first and second interconnection termination means (33,34);
said gate electrode (29, 30) being formed of a conductive material and located on an electrical insulating material (28) disposed on said major surface and comprising a first gate electrode (29) located in that separating space of said first intermediate region, and wherein there is a second gate electrode (30) formed of a conductive material and located on an electrical insulating material (28) disposed on said major surface in that separating space of said second intermediate region;
**characterised in that** the load current can be established by providing a signal beyond an initial value to said gate electrode, with said load current after such establishment having a magnitude which is independent of such signal over a range of signal values, and which after such establishment can be ended by providing a signal no longer beyond said initial value to said gate electrode.

2. A device according to claim 1 **characterised in that** said semiconductor material body has an additional second conductivity type region (21) adjoining said device region (22) opposite said major surface (23) and spaced apart from said second intermediate region (25).

3. A device according to claim 1 or 2, in which the first and second gate electrodes are electrically connected together thereby forming a single gate structure.

4. A device according to any preceding claim **characterised in that** each of said plurality of intermediate regions is located at an intersection of a mesh pattern in said first major surface portion.

5. A device according to any of claims 2 and 3 to 4 when dependent on claim 2 **characterised in that** said first intermediate region (24) is also spaced apart in said semiconductor material body from said additional second conductivity type region (21).

6. A device according to any of claims 2 and 3 to 4 when dependent on claim 2 **characterised in that** said first intermediate region (24) intersects said additional second conductivity type region (21).

7. A device according to any preceding claim **characterised in that** said first contact region (31) at least partly surrounds said first interior region (26) in said first major surface portion.

8. A device according to any of claims 1 to 6 **characterised in that** said first contact region (31) is at least partly surrounded by said first interior region (26) in said first major surface portion.

9. A device according to any of claims 1 to 6 and 8 **characterised in that** each said contact region (31, 32) in said plurality of contact regions is surrounded in its corresponding said intermediate region (24, 25) in said first major surface portion by that said interior region also located such that said first contact region (31) is surrounded by said first interior region (26) in said first major surface portion.

10. A device according to claim 9 **characterised in that** said device region (22) of said first conductivity type entirely surrounds, in said first major surface portion, each of said plurality of intermediate regions (24, 25).

11. A device according to claim 10 when dependent on claim 4 **characterised in that** any intermediate region in said plurality thereof, including said first intermediate region, which has said first gate electrode (29') located on an electrical insulating material (28) disposed **in that** separating space thereof, as aforesaid, also has its immediately neighbouring intermediate regions in said mesh pattern, including said second intermediate region (25'), having a common second gate electrode (30'), said second gate electrode (30') being formed of a conductive material and located on an electrical insulating material (28) disposed on said major surface in said separating space of each of said neighbouring intermediate regions.

12. A device according to any of claim 10 when dependent on claim 4, or 11 **characterised in** any intermediate region in said plurality thereof, including said first intermediate region (24') which has said first interconnection termination means (33') electrically connected to portions of that contact region therein, as aforesaid, also has its immediately neighbouring intermediate regions in said mesh pattern, including said second intermediate region (25'), having a common second termination means (34'),

13. A device according to any preceding claim in which each of said interior regions is surrounded by its corresponding intermediate region so as to be within 1.0 µm of said portion of its intermediate pn junction.

## Patentansprüche

1. Bilaterale (zweiseitige) Halbleiterschaltvorrichtung, **dadurch gekennzeichnet, daß** sie eine Gatterelektrode (29, 30) und erste (unter 33) und zweite (unter 34) Endbereiche aufweist, von denen jeder als eine Anode und Kathode derselben dienen kann, welche Schaltvorrichtung imstande ist, einen Laststrom, der zwischen den ersten und zweiten Endbereichen fließt, als einen Hauptstrom, der durch sie fließt, zu leiten, welche Vorrichtung aufweist:
einen Halbleitermaterialhauptteil, der eine erste größere Oberfläche (23) hat und einen Vorrichtungsbereich (22) eines ersten Leitfähigkeitstyps, z.B. n, und einer ersten Leitfähigkeit aufweist, der die größere Oberfläche (23) schneidet;
eine Mehrzahl von Zwischenbereichen (24, 25), die die erste größere Oberfläche (23) in einem ersten größeren Oberflächenbereich schneiden, die erste (24) und zweite (25) Zwischenbereiche einschließen, die voneinander in dem Vorrichtungsbereich (22) beabstandet sind und daher in dem ersten größeren Oberflächenbereich beabstandet sind, wobei jeder der Zwischenbereiche von einem zweiten Leitfähigkeitstyp, z.B. p, ist, um dadurch in jedem einen entsprechenden Zwischen-pn-Übergang mit dem Vorrichtungsbereich zu bilden, wobei ein Teil dieses Übergangs auf einer Seite des mit ihm verknüpften Zwischenbereiches ist, die dem ersten größeren Oberflächenbereich entgegengesetzt ist;
eine Mehrzahl von Kontaktbereichen (31, 32), von denen jeder den ersten größeren Oberflächenbereich schneidet, die erste (31) und zweite (32) Kontaktbereiche einschließen, wobei jeder der Kontaktbereiche in einem entsprechenden der Zwischenbereiche angeordnet ist, jedoch eine größere Leitfähigkeit hat, z.B. p+, als übrige Bereiche seines entsprechenden Zwischenbereiches, welcher erste Kontaktbereich (31) in dem ersten Zwischenbereich (24) und welcher zweite Kontaktbereich (32) in dem zweiten Zwischenbereich (25) ist; und
eine Mehrzahl von inneren Bereichen (26, 27), von denen jeder den ersten größeren Oberflächenbereich schneidet, die erste (26) und zweite (27) innere Bereiche einschließen, wobei jeder der inneren Bereiche in einem entsprechenden der Zwischenbereiche angeordnet ist, durch den entsprechenden Zwischenbereich umgeben ist und von dem Vorrichtungsbereich durch seinen entsprechenden Zwischenbereich beabstandet, um einen entsprechenden inneren pn-Übergang mit seinem entsprechenden Zwischenbereich zu bilden, den ersten größeren Oberflächenbereich schneidet und von seinem entsprechenden Zwischen-pn-Übergang getrennt ist, um einen resistiven Bereich des Zwischenbereichs zu bilden, der entlang dem inneren Bereich zwischen einem Teil des inneren pn-Übergangs und dem Teil seines entsprechenden Zwischen-pn-Übergangs und einem trennenden Raum zwischen dem inneren pn-Übergang und seinem entsprechenden Zwischen-pn-Übergang an dem größeren Oberflächenbereich angeordnet ist, wobei der erste innere Bereich (26) innerhalb des ersten Zwischenbereichs (24) liegt und der zweite innere Bereich (23) innerhalb des zweiten Zwischenbereiches (25) liegt, wobei die Mehrzahl von inneren Bereichen jeweils vom ersten Leitfähigkeitstyp ist, wobei der erste Endbereich wenigstens Teile des ersten inneren Bereiches (26) und des ersten Kontaktbereiches (31) einschließt und wobei der zweite Endbereich wenigstens Teile des zweiten inneren Bereiches (27) und des zweiten Kontaktbereiches (32) einschließt;
erste Verbindungsanschlußmittel (33), die elektrisch mit dem ersten Endbereich verbunden sind, und zweite Verbindungsanschlußmittel (34), die elektrisch mit dem zweiten Endbereich verbunden sind;
wobei die Kontaktbereiche Teile haben, die den Seiten der inneren Bereiche benachbart sind, die den Seiten der inneren Bereiche gegenüberliegen, die den trennenden Räumen benachbart sind, und wobei die ersten und zweiten Endbereiche wenigstens die Teile der ersten und zweiten Kontaktbereiche enthalten, die durch die entsprechenden ersten und zweiten Verbindungsanschlußmittel (33, 34) kontaktiert werden;
welche Gatterelektrode (29, 30) aus einem leitenden Material gebildet ist und auf einem elektrisch isolierenden Material (28) angeordnet ist, das auf der größeren Oberfläche angeordnet ist und eine erste Gatterelektrode (29) aufweist, die in dem trennenden Raum des ersten Zwischenbereiches angeordnet ist, und wobei eine zweite Gatterelektrode (30) vorhanden ist, die aus einem leitenden Material gebildet ist und auf dem elektrisch isolierenden Material (28) angeordnet ist, das auf der größeren Oberfläche in dem trennenden Raum des zweiten Zwischenbereiches angeordnet ist;
**dadurch gekennzeichnet, daß** der Laststrom dadurch eingerichtet werden kann, daß ein Signal, das über einem anfänglichen Wert liegt, an die Gatterelektrode angelegt wird, wobei der Laststrom nach einer solchen Einrichtung eine Größe hat, die unabhängig von einem solchen Signal über einen Bereich von Signalwerten ist, und der nach Einrichtung dadurch beendet werden kann, daß ein Signal, das nicht mehr über den anfänglichen Wert hinausgeht, an die Gatterelektrode angelegt wird.

2. Vorrichtung nach Anspruch 1, **dadurch gekennzeichnet, daß** der Halbleitermaterialhauptteil einen zusätzlichen Bereich (21) vom zweiten Leitfähigkeitstyp aufweist, der an den Vorrichtungsbereich (22) auf der entgegengesetzten Seite von der größeren Oberfläche (23) angrenzt und von dem zweiten Zwischenbereich (25) beabstandet ist.

3. Vorrichtung nach Anspruch 1 oder 2, in der die ersten und zweiten Gatterelektroden elektrisch miteinander verbunden sind, wodurch sie eine einzige Gatterstruktur bilden.

4. Vorrichtung nach einem vorangehenden Anspruch, **dadurch gekennzeichnet, daß** jede der Mehrzahl von Zwischenbereichen an einer Kreuzungsstelle eines Maschenmusters in dem ersten größeren Oberflächenbereich angeordnet ist.

5. Vorrichtung nach einem der Ansprüche 2 und 3 bis 4 in Abhängigkeit von Anspruch 2, **dadurch gekennzeichnet, daß** der erste Zwischenbereich (24) ebenfalls in dem Halbleitermaterialhauptteil von dem zusätzlichen Bereich (21) vom zweiten Leitfähigkeitstyp beabstandet ist.

6. Vorrichtung nach einem der Ansprüche 2 und 3 bis 4 in Abhängigkeit von Anspruch 2, **dadurch gekennzeichnet, daß** der erste Zwischenbereich (24) den zusätzlichen Bereich (22) vom zweiten Leitfähigkeitstyp schneidet.

7. Vorrichtung nach einem vorangehenden Anspruch, **dadurch gekennzeichnet, daß** der erste Kontaktbereich (31) wenigstens teilweise den ersten inneren Bereich (26) in dem ersten größeren Oberflächenbereich umgibt.

8. Vorrichtung nach einem der Ansprüche 1 bis 6, **dadurch gekennzeichnet, daß** der erste Kontaktbereich (31) wenigstens teilweise durch den ersten inneren Bereich (26) in dem ersten größeren Oberflächenbereich umgeben ist.

9. Vorrichtung nach einem der Ansprüche 1 bis 6 und 8, **dadurch gekennzeichnet, daß** jeder Kontaktbereich (31, 32) in der Mehrzahl von Kontaktbereichen in seinem entsprechenden Zwischenbereich (24, 25) in dem ersten größeren Oberflächenbereich durch den inneren Bereich umgeben ist, der so angeordnet ist, daß der erste Kontaktbereich (31) durch den ersten inneren Bereich (26) in dem ersten größeren Oberflächenbereich umgeben ist.

10. Vorrichtung nach Anspruch 9, **dadurch gekennzeichnet, daß** der Vorrichtungsbereich (22) des ersten Leitfähigkeitstyps vollständig in dem ersten größeren Oberflächenbereich jede der Mehrzahl von Zwischenbereichen (24, 25) umgibt.

11. Vorrichtung nach Anspruch 10 in Abhängigkeit von Anspruch 4, **dadurch gekennzeichnet, daß** irgendein Zwischenbereich in deren Mehrzahl einschließlich des Zwischenbereichs, bei dem die erste Gatterelektrode (29') auf einem elektrisch isolierenden Material (28) angeordnet, das in dem trennenden Raum desselben angeordnet ist, wie vorerwähnt ebenfalls seine unmittelbar benachbarten Zwischenbereiche in dem Maschenmuster hat, einschließlich des zweiten Zwischenraums (25'), der eine gemeinsame zweite Gatterelektrode (30') hat, wobei die zweite Gatterelektrode (30') aus einem leitenden Material gebildet ist und auf einem elektrisch isolierenden Material (28) angeordnet ist, das auf der größeren Oberfläche in dem trennenden Raum jedes der benachbarten Zwischenbereiche angeordnet ist.

12. Vorrichtung nach Anspruch 10 in Abhängigkeit von Anspruch 4 oder 11, **dadurch gekennzeichnet, daß** irgendein Zwischenbereich in der Mehrzahl derselben einschließ-lich des ersten Zwischenbereiches (24'), der die Verbindungsanschlußmittel (33') aufweist, die elektrisch mit Teilen des Kontaktbereiches darin verbunden sind, wie vorerwähnt auch seine unmittelbar benachbarten Zwischenbereiche in dem Maschenmuster hat, einschließlich des zweiten Zwischenbereiches (25'), die ein gemeinsames zweites Anschlußmittel (34') aufweisen.

13. Vorrichtung nach einem vorangehenden Anspruch, in dem jeder der inneren Bereiche durch seinen entsprechenden Zwischenbereich umgeben ist, um so innerhalb von 1,0 µm des Bereiches seines Zwischen-pn-Übergangs zu sein.

## Revendications

1. Commutateur semi-conducteur bidirectionnel, **caractérisé en ce qu'**il est pourvu d'une électrode de grille (29, 30) et de première (au-dessous de 33) et de seconde (au-dessous de 34) zones d'extrémité, dont chacune peut servir d'anode et de cathode, ledit commutateur étant capable de conduire, un courant principal le traversant, un courant de charge circulant entre lesdites première et deuxième zones d'extrémité, ledit dispositif comprenant :
un corps en matériau semi-conducteur ayant une première surface principale (23) et comprenant une zone de dispositif (22) d'un premier type de conductivité, par exemple n, et une première conductivité, croisant ladite surface principale (23);
une pluralité de zones intermédiaires (24, 25) croisant ladite première surface principale (23) dans une première partie de surface principale comprenant des première (24) et deuxième (25) zones intermédiaires qui sont espacées entre elles dans ladite zone de dispositif (22) et ainsi espacées dans ladite première partie de surface principale, chacune desdites zones intermédiaires étant d'un deuxième type de conductivité, par exemple p, pour résulter **en ce que** chacune forme une jonction pn intermédiaire correspondante avec ladite zone de dispositif, une partie de cette jonction étant sur un côté de sa zone intermédiaire associée qui est opposée à ladite première partie de surface principale;
une pluralité de zones de contact (31, 32), chacune croisant ladite première partie de surface principale, comprenant des première (31) et deuxième (32) zones de contact avec chacune desdites zones de contact et étant situées dans une zone correspondante desdites zones intermédiaires mais de conductivité plus grande, par exemple p+, que les parties restantes de la dite zone intermédiaire correspondante, ladite première zone de contact (31) étant dans ladite première zone intermédiaire (24) et ladite deuxième zone de contact (32) étant dans ladite zone intermédiaire (25); et
une pluralité de zones intérieures (26, 27), chacune croisant ladite première partie de surface principale, comprenant des première (26) et deuxième (27) zones intérieures, avec chacune desdites zones intérieures étant située dans une zone correspondante desdites zones intermédiaires, entourée par ladite zone intermédiaire correspondante et espacée de ladite zone de dispositif par sa zone intermédiaire correspondante pour former une jonction pn intérieure correspondante avec sa zone intermédiaire correspondante, croisant ladite première partie de surface principale et séparée de sa dite jonction pn intermédiaire 'correspondante pour fournir une partie résistive de cette zone intermédiaire située le long de ladite zone intérieure entre une partie de ladite jonction pn intérieure et de ladite partie de sa jonction pn intermédiaire correspondante et un espace de séparation entre ladite jonction pn intérieure et sa jonction pn intermédiaire correspondante à ladite partie de surface principale, ladite première zone intérieure (26) étant dans ladite première zone intermédiaire (24) et ladite deuxième zone intérieure (23) étant dans ladite deuxième zone intermédiaire (25), lesdites plusieurs zones intérieures étant chacune dudit premier type de conductivité avec ladite première zone d'extrémité comprenant au moins des parties de ladite première zone intérieure (26) et de ladite première zone de contact (31) et avec ladite deuxième zone d'extrémité comprenant au moins des parties de ladite deuxième zone intérieure (27) et de ladite deuxième zone de contact (32) ;
des premiers moyens d'extrémité d'interconnexion (33) connectés électriquement à la première zone d'extrémité, et un deuxième moyen d'extrémité d'interconnexion (34) connecté électriquement à la deuxième zone d'extrémité;
les zones de contact ayant des parties adjacentes aux côtés des zones intérieures qui sont opposées aux côtés des zones intérieures adjacentes aux espaces de séparation, et les première et deuxième zones d'extrémité comprennent respectivement au moins lesdites parties des première et deuxième zones de contact qui sont en contact avec les premier et second moyens d'extrémité d'interconnexion respectifs (33, 34) ;
ladite électrode de grille (29, 30) étant formée d'un matériau conducteur et située sur un matériau diélectrique (28) placé sur ladite surface principale et comprenant une première électrode de grille (29) située dans cet espace de séparation de ladite première zone intermédiaire, et dans lequel il y a une deuxième électrode de commande (30) formée d'un matériau conducteur et située sur un matériau diélectrique (28) placé sur ladite surface principale dans cet espace de séparation de ladite deuxième zone intermédiaire ;
**caractérisé en ce que** le courant de charge peut être établi en appliquant un signal au-delà d'une valeur initiale à ladite électrode de commande, avec ledit courant de charge après un tel établissement ayant une grandeur qui est indépendante d'un tel signal sur une gamme de valeurs de signal, et qui après un tel établissement peut être interrompu en n'appliquant plus de signal au-delà de ladite valeur initiale à ladite électrode de commande.

2. Dispositif selon la revendication 1, **caractérisé en ce que** ledit corps en matériau semi-conducteur a une zone supplémentaire du deuxième type de conductivité (21) joignant ladite zone de dispositif (22) opposée à ladite surface principale (23) et espacée de ladite deuxième zone intermédiaire (25).

3. Dispositif selon la revendication 1 ou 2, dans lequel les première et deuxième électrodes de commande sont connectées électriquement entre elles formant ainsi une structure de commande unique.

4. Dispositif selon l'une quelconque des revendications précédentes, **caractérisé en ce que** chacune desdites plusieurs zones intermédiaires est située à une intersection d'un motif en grille dans ladite première partie de surface principale.

5. Dispositif selon l'une quelconque des revendications 2 et 3 à 4 lorsque dépendant de la revendication 2, **caractérisé en ce que** ladite première zone intermédiaire (24) est également espacée dans ledit corps en matériau semi-conducteur de ladite zone supplémentaire du deuxième type de conductivité (21).

6. Dispositif selon l'une quelconque des revendications 2 et 3 à 4 lorsque dépendant de la revendication 2, **caractérisé en ce que** ladite première zone intermédiaire (24) croise ladite zone supplémentaire du deuxième type de conductivité (21).

7. Dispositif selon l'une quelconque des revendications précédentes, **caractérisé en ce que** ladite première zone de contact (31) entoure au moins partiellement ladite première zone intérieure (26) dans ladite première partie de surface principale.

8. Dispositif selon l'une quelconque des revendications 1 à 6, **caractérisé en ce que** ladite première zone de contact (31) est entourée au moins partiellement par ladite première zone intérieure (26) dans ladite première partie de surface principale.

9. Dispositif selon l'une quelconque des revendications 1 à 6 et 8, **caractérisé en ce que** chaque dite zone de contact (31, 32) dans lesdites plusieurs zones de contact est entourée dans sa dite zone intermédiaire correspondante (24, 25) dans ladite première partie de surface principale par ladite zone intérieure également située de telle sorte que ladite première zone de contact (31) est entourée par ladite première zone intérieure (26) dans ladite première partie de surface principale.

10. Dispositif selon la revendication 9, **caractérisé en ce que** ladite zone de dispositif (22) dudit premier type de conductivité entoure complètement, dans ladite première partie de surface principale, chacune des desdites plusieurs zones intermédiaires (24, 25).

11. Dispositif selon la revendication 10 lorsque dépendant de la revendication 4, **caractérisé en ce que** n'importe quelle zone intermédiaire dans sa dite pluralité, comprenant ladite première zone intermédiaire, qui a ladite première électrode de commande (29') située sur un matériau diélectrique (28) placé dans cet espace de séparation, comme susmentionné, a aussi ses zones intermédiaires à proximité immédiate dans ledit motif en grille, comprenant ladite deuxième zone intermédiaire (25'), ayant une deuxième électrode de commande commune (30'), ladite deuxième électrode de commande (30') étant formée d'un matériau conducteur et située sur un matériau diélectrique (28) placé sur ladite surface principale dans ledit espace de séparation de chacune desdites zones intermédiaires adjacentes.

12. Dispositif selon la revendication 10 lorsque dépendant de la revendication 4, ou 11, **caractérisé en ce que** n'importe quelle zone intermédiaire dans sa dite pluralité, comprenant ladite première zone intermédiaire (24') qui a ledit premier moyen d'extrémité d'interconnexion (33') connecté électriquement à des parties de cette zone de contact à l'intérieur, comme susmentionné, a aussi ses zones intermédiaires à proximité immédiate dans ledit motif en grille, comprenant ladite deuxième zone intermédiaire (25'), ayant un deuxième moyen d'extrémité commun (34').

13. Dispositif selon l'une quelconque des revendications précédentes, dans lequel chacune desdites zones intérieures est entourée par sa zone intermédiaire correspondante afin d'être à moins de 1,0 µm de ladite partie de sa jonction pn intermédiaire.
